# DEMANDE DE BREVET EUROPEEN

(11) **EP 1 868 004 A2**
(43) Date de publication de la demande: **19.12.2007**
(21) Numéro de dépôt: 07290706.6
(22) Date de dépôt: 07.06.2007
(51) Int. Cl.: G01R 33/00, B63G 9/06

(54) **Dispositif et procédé associés de mesure de la signature magnétique d'un bateau**

(30) Priorité: 09.06.2006 FR 0605113
(71) Demandeur: ETAT-FRANCAIS représenté par le Délégué Général pour l' Armement, 94114 Arcueil Cedex (FR)
(72) Inventeur: Brussieux, Marc, 29200 Brest (FR)

(57) **Abrégé**

La présente invention concerne le domaine des appareils pour la mesure des grandeurs magnétiques et a plus particulièrement pour objet un dispositif portable de mesure de la signature magnétique d'un bateau comportant plusieurs capteurs magnétiques (2,5) solidaires de moyens mobiles marins (1) autopropulsés par des moyens de propulsion (12), caractérisé en ce que, de part sa masse, ce dispositif est aptes à être hissé sur un bateau de type chalutier, frégate, voire zodiac. D'une manière préférentielle, les moyens mobiles sous-marins (1) autopropulsés sont constitués par un zodiac ou par un véhicule sous-marin non habité.

## Description

La présente invention concerne le domaine des appareils pour la mesure des grandeurs magnétiques et a plus particulièrement pour objet une station portable de mesure de la signature magnétique d'un bâtiment naval.

La discrétion des bâtiments de surface et sous-marins est une contrainte opérationnelle forte contre une menace d'interception adverse et contre la menace mine. La mesure des indiscrétions commises est généralisée dans toutes les marines et standardisée au sein de l'OTAN par les STANAGS.

Les navires et les engins sous-marins, tous désignés dans ce qui suit par le terme générique de bateau, sont régulièrement contrôlés sur des polygones de mesure dans le but de mesurer leurs niveau d'indiscrétion acoustique, magnétique et électromagnétique, influences qui les rendent potentiellement détectables par les forces adverses et les mines.

Ces polygones sont composés le plus communément d'un ensemble de capteurs respectivement acoustiques, magnétiques et électromagnétiques posés sur le fond ou en suspension dans la colonne d'eau, reliés à un système d'enregistrement et d'analyse des signaux au moyen d'un ensemble de câbles et de systèmes de transmission.

Selon l'état de l'art, lors d'une opération de contrôle, le bateau à étudier se déplace au voisinage des capteurs du polygone. Pendant son déplacement, on mesure et on enregistre la position relative du bateau par rapport à celles des capteurs du polygone en même temps que les signaux issus des capteurs du polygone. Les positions et les signaux sont analysés au moyen de calculateurs et de logiciels de traitement qui caractérisent les bruits rayonnés par le bateau et mesurent son niveau d'indiscrétion.

Ces analyses font l'objet de rapports qui sont exploités par les différents acteurs concernés.

Cependant, de telles installations présentent de nombreux inconvénients. Ainsi, les polygones de mesure sont le plus souvent fixes et constituées de capteurs posés sur des socles au fond de l'eau ou attachés par des câbles au fond de la mer. Les mesures sont donc réalisées dans un environnement souvent défavorable du notamment à la faible profondeur, à la proximité de sources de bruit acoustique, électromagnétique et magnétique ou au passages parasites d'autres bateaux.

L'immobilité des polygones de mesure crée une dépendance fonctionnelle et géographique entre le navire et le polygone de contrôle. Cette dépendance peut s'étendre dans le temps en fonction des aléas météo et techniques (pannes de matériels), qui entraînent une réduction de la disponibilité opérationnelle du bateau pendant la durée du contrôle.

De plus, les polygones constituent une infrastructure lourde, coûteuse et difficile à mettre en oeuvre et à maintenir nécessitant la présence de plongeurs, de nombreux capteurs, de nombreux câbles sous-marins, d'installations à terre, d'interdictions de navigation dans la zone, un armement temporaire par du personnel à déplacer sur site. Ils nécessitent aussi une surface d'installations important, des sites militaires protégés devant la mer avec des installations sous-marines et donc une zone du littorales réservées.

De surcroît, chaque polygone étant installé sur un site géographique spécifique, les résultats de mesure pour un même bateau peuvent varier selon le polygone choisi, en raison notamment des modes opératoires et conditions d'environnement locales comme l'épaisseur de la lame d'eau, la forme et la nature des fonds, les niveaux des bruits ambiants, les disparités des matériels et des procédures employés.

Par ailleurs les polygones ne peuvent être transportés et déployés dans un théâtre opérationnel. Suite à avarie, endommagement, ou après un long trajet pour rejoindre un théâtre de bataille, un bateau ne peut connaître son nouveau niveau d'indiscrétion faute de pouvoir repasser sur son polygone de mesure : il doit faire des hypothèses sur la menace qu'il encoure.

En outre certaines polygones ne peuvent pas physiquement réaliser des mesures en champ lointain, en raison de l'environnement local (relief et proximité des fonds, espacement insuffisant des capteurs, réverbération). L'indiscrétion en champ lointain doit dans ce cas être calculée à partir de mesures incertaines réalisées en champ proche et de modèles introduisant des incertitudes supplémentaires mal maîtrisées.

On connaît toutefois la demande de brevet FR2679514 qui décrit une station portable de mesure et de réglage de la signature numérique d'un bâtiment naval comportant plusieurs capteurs magnétiques reliés entre eux de façon à former un chapelet déformable destiné à être déposé au fond de la mer et auxquels sont associés des moyens de transmission des données qu'il fournissent comportant une antenne disposée sur une bouée lestée à l'extérieur de l'eau. Le positionnement des capteurs magnétiques par rapport au bateau est déterminé à l'aide de capteurs de pression associés aux capteurs magnétiques, au calcul de la dérivée seconde du champ magnétique et par une méthode de tracking utilisant des moyens de visée optiques, acoustiques ou magnétiques.

Cette station portable, comporte aussi un certain nombre d'inconvénients. Elle nécessite d'une part la présence d'un fond peu profond, donc la présence du littoral et donc d'un environnement souvent défavorable, et d'autre part la présence de plongeurs pour déposer le chapelet de capteurs magnétiques. Elle nécessite aussi la détermination du positionnement relatif de chacun des capteurs magnétiques ce qui peut conduire à l'évaluation d'une signature magnétique erronée si le positionnement n'est pas déterminé précisément. En outre, la mise en oeuvre de cette station conduit, à chaque fois, à la perte des moyens de lestage.

Pour résoudre une partie de ces inconvénients, le brevet FR2704065 décrit l'utilisation d'une antenne acoustique ayant une longueur de plusieurs centaines de mètres, connue sous le nom de flûte et normalement utilisée pour la détection acoustique et tirée par le bâtiment naval à caractériser.

Un tel dispositif ne permet de caractériser le magnétisme du bâtiment naval que vers l'arrière ce qui est insuffisant pour déterminer les propriétés magnétiques globales du bâtiment naval.

On connaît par ailleurs la demande de brevet EP356146 qui décrit une structure de grande dimension en forme de U selon trois axes perpendiculaires comportant des chambres de flottaison et sur laquelle sont fixés des capteurs magnétiques. La distance entre les deux branches du U doit être supérieure à la largeur du navire à caractériser, en l'occurrence un sous-marin, et elle comporte des moyens d'accrochage sur un sous-marin pour son transport.

Cette structure a l'inconvénient d'être encombrante et de perturber considérablement les performances, notamment de vitesse, du sous-marin lorsqu'elle lui est accrochée.

Le but de l'invention est de proposer un dispositif portable de mesure de la signature magnétique d'un bateau ne nécessite pas la présence d'un fond peu profond, donc d'un environnement souvent défavorable, ni la présence de plongeurs ni la détermination du positionnement relatif de chacun des capteurs magnétiques, ni la perte des moyens de lestage après chaque utilisation et permettant une caractérisation des propriétés magnétiques d'un navire dans toutes les directions sans affecter ou presque les performances d'un bâtiment naval apte à le porter et adapté à mesurer les caractéristiques magnétiques d'un navire quel que soit sa forme et sa taille.

La solution apportée est un dispositif portable de mesure de la signature magnétique d'un bateau comportant plusieurs capteurs magnétiques solidaires de moyens mobiles marins autopropulsés par des moyens de propulsion caractérisé en ce que, de part sa masse, ce dispositif est apte à être hissé sur un bateau de type chalutier, frégate, voire zodiac. Ainsi, ce dispositif peut être transporté par pratiquement tous les types de navire et peut assurer sa caractérisation magnétique ou celle d'un autre bâtiment quel que soit l'endroit où il se trouve, et ce sans dégrader de manière important les performances, notamment de vitesse et acoustiques, du navire qui le transporte.

Selon une caractéristique particulière, les moyens mobiles marins autopropulsés sont constitués par un zodiac ou par un véhicule sous-marin non habité.

Selon une autre caractéristique permettant notamment de pouvoir déterminer les caractéristiques magnétique d'un bâtiment tout autour de lui et au-dessous, les moyens mobiles marins autopropulsés sont constitués par un véhicule sous-marin non habité et un dispositif selon l'invention comporte des moyens de programmation de la trajectoire des moyens mobiles sous-marins en fonction de la position relative entre le bateau et ces moyens mobiles, ou des moyens de télécommande à distance de la trajectoire des moyens mobiles sous-marins.

Selon une autre caractéristique, facilitant le hissage et la mise à l'eau des moyens mobiles marins, la masse des moyens marins autopropulsés et des capteurs magnétiques associés est inférieure à 3 tonnes et préférablement inférieure à 1 tonne, voire inférieure à 200kg.

Selon un mode préféré de réalisation, ce dispositif portable comporte des moyens d'acquisition de signaux issus des dits capteurs magnétiques et des moyens de stockage de données relatives à ces signaux.

Selon une caractéristique additionnelle, ce dispositif portable comporte au moins un connecteur pour moyens extérieurs aptes à télécharger les données stockées dans lesdits moyens de stockage.

Selon une autre caractéristique, ce dispositif portable comporte des moyens de détermination de la position relative du bateau par rapport à l'engin, ces moyens pouvant consister en au moins un hydrophone.

Selon une autre caractéristique, ce dispositif portable comporte des moyens de détermination de la position absolue de l'engin par rapport au référentiel terrestre.

Selon une autre caractéristique, ce dispositif portable comporte au moins l'un des capteurs suivants :
- un hydrophone,
- un capteur de champ ou de gradient magnétique,
- un capteur de champ électromagnétique ou de courant électrique
- un capteur de vitesse particulaire
- un capteur optique pour mesurer la photoluminescence
- un sondeur acoustique actif apte à mesurer les index acoustiques de coques, des revêtements anéchoïques et les index acoustiques de sillages.

L'invention concerne aussi un premier procédé de mesure de la signature d'un bateau avec un dispositif portable selon l'invention, caractérisé en ce qu'il comporte une étape dans laquelle le dispositif suit une trajectoire passant autour du bateau, les capteurs magnétiques étant aptes à mesurer le rayonnement magnétique rayonné par le bateau tout au long de cette trajectoire.

L'invention concerne aussi un second procédé de mesure de la signature d'un bateau avec un dispositif portable selon l'invention, caractérisé en ce qu'il comporte une étape dans laquelle le dispositif suit une trajectoire le menant sur le fond marin où d'une part ses moyens de propulsion sont stoppés et d'autre part les capteurs magnétiques sont aptes à mesurer le rayonnement magnétique rayonné par le bateau tout au long de cette trajectoire.

Ainsi, l'invention apporte au bateau la capacité de réaliser lui-même ses propres mesures des bruits qu'il rayonne dans toutes les directions, à l'endroit géographique où ils se trouvent, sur par exemple un théâtre opérationnel, loin de leurs polygones habituels.

L'invention est à la fois une méthode et un système implémentant cette méthode permettant le contrôle des indiscrétions acoustiques, magnétiques et électromagnétiques des bateaux, qui évite les inconvénients cités ci-dessus.

Des économies substantielles peuvent en résulter : réduction du nombre et des coûts d'intervention des équipes actuelle de contrôle sur polygones, L'invention utilise des moyens mobiles, qui sont récupérés après chaque mesure, qui ne nécessitent aucune infrastructure fixe et permettent une maintenance aisée après récupération à bord.

D'autres avantages et caractéristiques apparaîtront dans la description d'un mode de réalisation de l'invention au regard des figures annexées parmi lesquelles:
- la figure 1 est un schéma simplifié d'un dispositif de mesure de la masse volumique de particules selon un mode de réalisation de l'invention,
- la figure 2 présente un schéma complet d'un dispositif de mesure de la masse volumique de particules selon ce mode de réalisation de l'invention

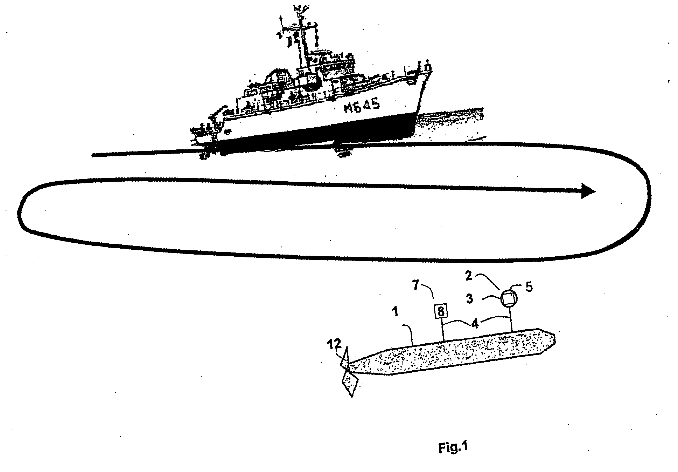

Comme montré sur la figure 1, un dispositif de mesure de la signature magnétique d'un bateau selon ce mode de réalisation de l'invention comporte d'une part des moyens mobiles autopropulsés constitués par un engin sous-marin autonome 1 et d'autre part des moyens 2 associés aptes à mesurer la signature magnétique d'un bateau.

L'engin sous marin autonome utilisé dans ce mode de réalisation est commercialisé par, la société HYDROID Inc, et baptisé REMUS 100. Il est autopropulsé par une hélice et sa trajectoire peut être commandée à distance ou programmée. Sa masse de 37kg lui permet d'être manipulé par deux personnes, et l'installation des moyens 2 associés aptes à mesurer la signature magnétique d'un bateau conduit à une masse totale inférieure à 50kg. De part leur masse, l'engin sous-marin autonome 1 et les moyens 2 associés aptes à mesurer la signature magnétique d'un bateau peuvent être hisser et mis à l'eau à partir de quasiment n'importe quel bâtiment marin du zodiac ou sous-marin en passant notamment par les chalutiers et les frégates.

Cet engin mobile est à la fois léger, manipulable par un homme seul, de faible encombrement et ne nécessite pas de système spécifique de stockage ou de mise en oeuvre depuis un bateau. Il est en outre construit en matériaux non magnétiques.

Sur cet engin, ont été fixés des moyens 2 aptes à mesurer la signature magnétique d'un bateau constitués par un magnétomètre trois axes 5 de type connu, comme par exemple ceux commercialisés par la société ULTRA et disposé à l'intérieur d'une gaine rigide 3 fixée à l'extérieur de la coque dudit engin 1 par un tube 4. L'intérieur de la gaine rigide 3 est en communication avec l'intérieur de l'engin 1.

Le magnétomètre 3 axes utilisé intègre son électronique de conditionnement de signal.

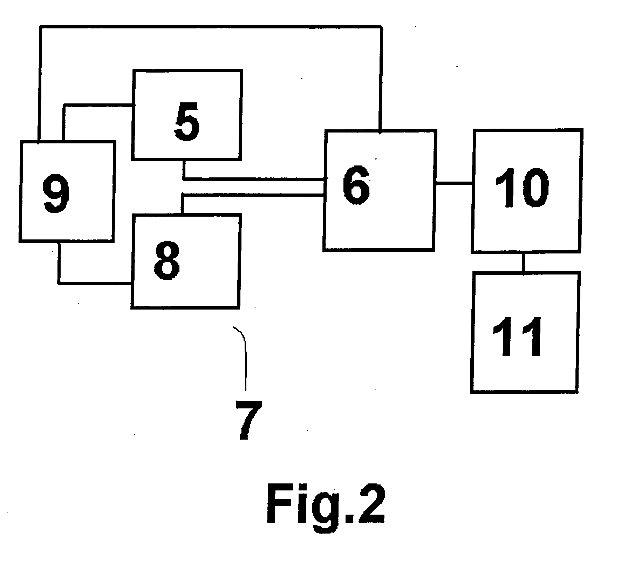

Comme montré sur la figure 2, le magnétomètre trois axes 5 est connecté à des moyens 6 d'acquisition de signaux, par exemple une carte équipée de convertisseurs A/D, d'interfaces et de moyens 10 de stockage de données par exemple de type disque dur ou mémoire flash.

L'engin est aussi équipé de moyens 7 de détermination de la position relative du bateau par rapport à l'engin. Ces moyens sont constitués par un hydrophone omnidirectionnel 8 de type connu fixé à l'extérieur de la coque de l'engin 1 et connecté aux moyens 6 d'acquisition de signaux par une liaison étanche.

Des moyens d'alimentation électrique 9 alimentent le magnétomètre 5, les moyens 6 d'acquisition de signaux ainsi que l'hydrophone 8 ainsi que le moteur électrique de l'engin 1 et une télécommande permet de mettre sous tension les différents équipements. Un connecteur 11, par exemple de type RS232 ou USB protégé par un capot étanche permet de connecter lesdits moyens 10 de stockage de données à des moyens de traitement extérieurs aptes à télécharger les signaux enregistrés dans ces moyens 10 de stockage.

Le fonctionnement du dispositif selon ce mode de réalisation de l'invention est le suivant :

L'engin est positionné à la surface de l'eau et mis en fonctionnement par action sur la télécommande. Le moteur entraîne alors l'hélice 12 de l'engin 1 et les moyens 6 d'acquisition de signaux commencent à enregistrer les signaux provenant du magnétomètre 5 et de l'hydrophone 8, ce dernier permettant de déterminer la position relative de l'engin 1 par rapport au bateau. Dans le cas ou le fond est peu profond, typiquement inférieur à 30 m, l'engin est programmé pour aller se poser sur le fond et son moteur est arrêté de façon à supprimer toute émission électromagnétique due au moteur de l'engin 1. Le bateau dont la signature magnétique doit être déterminée est ensuite déplacé selon une trajectoire déterminée et les moyens 10 de stockage enregistrent les données relatives aux signaux magnétiques et acoustiques provenant du bateau pendant toute la durée de ladite trajectoire.

L'engin 1 est ensuite remis en fonctionnement et ramené jusqu'au navire afin d'y être repêché.

Dans le cas où les fonds marins sont profonds, le bateau est immobilisé tandis que l'engin est programmé pour décrire une trajectoire sous-marine qui préférablement passe à la verticale du bateau ainsi que de part et d'autre de façon à pouvoir évaluer la signature du bateau selon toutes les directions.

L'engin 1 est ensuite ramené jusqu'au navire afin d'y être repêché. A bord du navire, le capot étanche est ôté et les moyens de traitements disposés à bord du bateau sont connectés aux moyens 10 de stockage de données et les données enregistrées sont téléchargées par les moyens de traitement puis traitées de façon à déterminer, de façon connue, la signature magnétique du bateau. Dans le cas où les mesures ont été faites alors que l'engin 1 était en fonctionnement, la signature magnétique de l'engin est retranchée de celle mesurée de façon à ce que seule la signature magnétique du bateau soit déterminée.

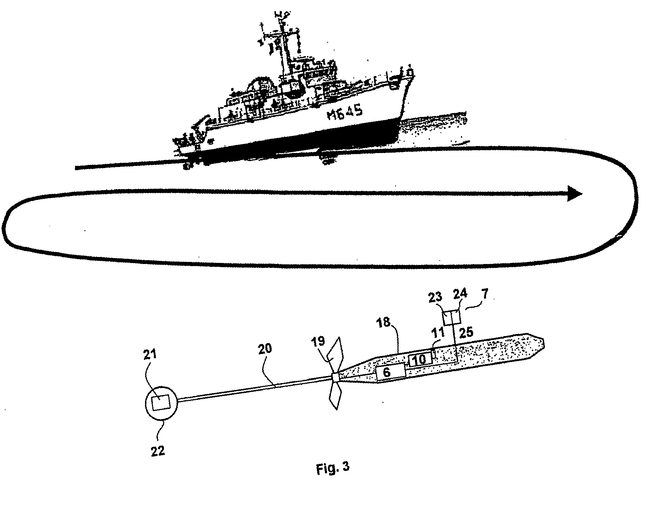

La figure 3 montre un dispositif de mesure de la signature magnétique d'un bateau selon un second mode de réalisation de l'invention comportant un engin 18 similaire à celui décrit précédemment mais comportant des moyens de mesures de la signature magnétique d'un bateau disposés différemment.

L'engin 18 comporte tout d'abord une hélice 19 reliée à un arbre d'hélice de forme tubulaire et un tube rigide 20, de diamètre extérieur sensiblement égal au diamètre interne de l'arbre de l'hélice, est placé en partie, à l'intérieur et de manière concentrique à l'arbre d'hélice. Ce tube rigide 20 relie un magnétomètre 21 à l'intérieur de l'engin et des joints assurent l'étanchéité entre l'arbre d'hélice et le tube rigide.

Les moyens de mesure sont composés d'un magnétomètre trois axes 21 disposé à l'extrémité du tube rigide 20 fixé à l'arrière de l'engin à l'intérieur d'une gaine rigide 22. Cette déportation des capteurs magnétiques 21 permet de diminuer l'influence de la signature magnétique de l'engin 18 sur la mesure de celle du bateau. La longueur du tube rigide 20 est d'environ 3 mètres.

Comme dans l'exemple précédant, le magnétomètre trois axes 21 est connecté à des moyens 6 d'acquisition de signaux eux même connectés d'une part à des moyens 10 de stockage de données numérique et d'autre part à des moyens 7 de détermination de la position relative du bateau par rapport à l'engin par des moyens acoustiques en l'occurrence deux hydrophones omnidirectionnels 23,24 disposés à l'extrémité d'un tube 25.

La mise en oeuvre de ce dispositif est la même que dans le cadre de la première variante de réalisation de l'invention.

Avec un dispositif selon l'invention, la mesure de la signature magnétique d'un bateau est caractérisée par le déploiement par le bateau lui-même (capacité organique) ou par un bateau de soutien d'un ou plusieurs moyens mobiles de mesure, à l'endroit où il se trouve sur le globe, pour constituer un polygone de contrôle local.

Les mesures peuvent ainsi être avantageusement effectuées au large, dans un environnement moins perturbé par la proximité des fonds et les bruiteurs que l'environnement typique des polygones de mesure. Les mesures gagnent ainsi en qualité.

Un autre avantage vient de la nouvelle capacité donnée par l'invention au bateau de mesurer ses bruits rayonnés dans l'environnement local spécifique de la zone opérationnelle où il doit agir, et dans les conditions exactes d'avarie ou de modifications où il se trouve au moment de l'action.

La mobilité d'un dispositif selon l'invention lui permet de venir se placer en des points de l'espace où ils effectuent au moins une mesure de l'indiscrétion du bateau. Par opposition, les moyens actuels tels que les bouées déployables ne peuvent pas accéder à tous les points de l'espace utiles, notamment sous la quille du bateau. La mobilité constitue une caractéristique et un avantage de la méthode et permet de mesurer les indiscrétions du bateau dans toutes les directions de l'espace, et ainsi d'accéder à la fonction de directivité des émissions de bruits. En outre, le mobile selon l'invention peut s'éloigner à grande distance du bateau pour effectuer des mesures en champ lointain, ou s'en rapprocher pour effectuer des mesures en champ proche.

De nombreuses modifications peuvent être apportées aux exemples de réalisation précités sans sortir du cadre de l'invention.

Ainsi les capteurs magnétiques peuvent par exemple être des capteurs de champ ou de gradient magnétique.

De plus, un dispositif portable selon l'invention peut comporter, en outre, au moins un capteur choisi préférentiellement dans la liste suivante et permettant de mesurer une grandeur autre que la signature magnétique d'un bateau :
- un hydrophone destiné à mesurer les pressions et bruits acoustiques
- un capteur de champ électromagnétique ou de courant électrique
- un capteur de vitesse particulaire pour mesurer les ondes de sillage
- un capteur optique pour mesurer la photoluminescence
- un sondeur acoustique actif pour mesurer les index acoustiques de coques, des revêtements anéchoïques et les index acoustiques de sillages.

Un dispositif selon l'invention peut comporter un système de positionnement acoustique relatif par rapport au bateau, par exemple de type 'base courte', ou absolu par rapport au référentiel terrestre, par exemple de type 'GPS sous-marin', ou autre.

Dans le cadre de l'invention, le bateau peut passer au voisinage du véhicule autonome sans être gêné par le risque de collision avec lui, contrairement aux bouées, puisque le véhicule autonome peut se placer à une immersion telle que le bateau passe au dessus ou en dessous. Le véhicule autonome est, comme dans le cas précédent, récupéré par le bateau en fin d'opérations, et ses données téléchargées vers le calculateur de dépouillement.

Un dispositif selon l'invention permet aussi de déterminer la signature magnétique d'un sous-marin ce qui n'est pas possible avec une bouées ou avec une station portable comme celle décrite dans le brevet FR2679514.

## Revendications

**1.** Dispositif portable de mesure de la signature magnétique d'un bateau comportant plusieurs capteurs magnétiques (2,5) solidaires de moyens mobiles marins (1) autopropulsés par des moyens de propulsion (12, 19), **caractérisé en ce que**, de part sa masse, ce dispositif est aptes à être hissé sur un bateau de type chalutier, frégate, voire zodiac.

**2.** Dispositif portable selon la revendication 1, **caractérisé en ce que** de les moyens mobiles marins (1) autopropulsés sont constitués par un zodiac ou par un véhicule sous-marin non habité.

**3.** Dispositif selon l'une quelconque des revendications 1 et 2, **caractérisé en ce que** les moyens mobiles marins (1) autopropulsés sont constitués par un véhicule sous-marin non habité et **en ce qu'**il comporte des moyens de programmation de la trajectoire des moyens mobiles sous-marins en fonction de la position relative entre le bateau et ces moyens mobiles, ou des moyens de télécommande à distance de la trajectoire des moyens mobiles sous-marins.

**4.** Dispositif selon l'une quelconque des revendications 1 et 2, **caractérisé en ce que** la masse des moyens marins autopropulsés et des capteurs magnétiques associés est inférieure à 3 tonnes et préférablement inférieure à 1 tonne, voire inférieure à 200kg.

**5.** Dispositif selon l'une quelconque des revendications 1 à 4, **caractérisé en ce que** ce dispositif portable comporte des moyens (6) d'acquisition de signaux issus des dits capteurs magnétiques et des moyens de stockage (10) de données relatives à ces signaux.

**6.** Dispositif selon la revendication 5, **caractérisé en ce que** ce dispositif portable comporte au moins un connecteur (11) pour moyens extérieurs aptes à télécharger les données stockées dans lesdits moyens (10) de stockage.

**7.** Dispositif selon l'une quelconque des revendications 1 à 6, **caractérisé en ce que** ce dispositif portable comporte des moyens (8) de détermination de la position relative du bateau par rapport à l'engin, ces moyens pouvant consister en au moins un hydrophone (8).

**9.** Dispositif selon l'une quelconque des revendications 1 à 8, **caractérisé en ce que** ce dispositif portable comporte au moins l'un des capteurs suivants :
- un hydrophone,
- un capteur de champ ou de gradient magnétique,
- un capteur de champ électromagnétique ou de courant électrique
- un capteur de vitesse particulaire
- un capteur optique pour mesurer la photoluminescence
- un sondeur acoustique actif apte à mesurer les index acoustiques de coques, des revêtements anéchoïques et les index acoustiques de sillages.

**10.** Procédé de mesure de la signature d'un bateau utilisant un dispositif selon l'une quelconque des revendications 1 à 9, **caractérisé en ce qu'**il comporte une étape dans laquelle le dispositif suit une trajectoire passant autour du bateau, les capteurs magnétiques (2,5) étant aptes à mesurer le rayonnement magnétique rayonné par le bateau tout au long de cette trajectoire.

**11.** Procédé de mesure de la signature d'un bateau utilisant un dispositif selon l'une quelconque des revendications 1 à 9, **caractérisé en ce qu'**il comporte une étape dans laquelle le dispositif suit une trajectoire le menant sur le fond marin où d'une part ses moyens de propulsion sont stoppés et d'autre part les capteurs magnétiques (2,5) sont aptes à mesurer le rayonnement magnétique rayonné par le bateau tout au long de cette trajectoire.
